# EUROPEAN PATENT SPECIFICATION

(11) **EP 4 198 752 B1**
(45) Date of publication and mention of the grant of the patent: **20.05.2026**
(21) Application number: 20950890.2
(22) Date of filing: 31.08.2020
(51) Int. Cl.: G06F 13/40, H03K 19/0175

(54) **CHIP AND CHIP PACKAGE**
CHIP UND CHIPGEHÄUSE
PUCE ET BOÎTIER DE PUCE

(43) Date of publication of application: 21.06.2023
(73) Proprietor: Huawei Technologies Co., Ltd., Shenzhen, Guangdong 518129 (CN)
(72) Inventor: JIA, Hailin, Shenzhen, Guangdong 518129 (CN); ZHANG, Guangyu, Shenzhen, Guangdong 518129 (CN); FENG, Jun, Shenzhen, Guangdong 518129 (CN); WANG, Shaohua, Shenzhen, Guangdong 518129 (CN)
(74) Representative: Epping - Hermann - Fischer
(86) International application number: PCT/CN2020/112590
(87) International publication number: WO 2022/041221

(56) References cited:
- CN-A- 103 207 849
- CN-A- 103 999 008
- CN-A- 108 352 378
- US-A- 5 880 607
- US-A1- 2019 050 519
- US-B2- 9 647 668
- SOOMRO IFTIKHAR A ET AL: "Test Time Reduction of 3-D Stacked ICs Using Ternary Coded Simultaneous Bidirectional Signaling in Parallel Test Ports", IEEE TRANSACTIONS ON COMPUTER-AIDED DESIGN OF INTEGRATED CIRCUITS AND SYSTEMS, IEEE, USA, vol. 39, no. 12, 3 March 2020 (2020-03-03), pages 5225 - 5237, XP011821097, ISSN: 0278-0070, [retrieved on 20201119], DOI: 10.1109/TCAD.2020.2977604

## Description

### TECHNICAL FIELD

This application relates to the field of chip interconnection technologies, and in particular, to a chip and a chip package.

### BACKGROUND

A 3D (three dimensional, three dimensional) package on package (which may also be referred to as a 3D IC) has advantages of a small package area, low costs, and high integration, and has become a development direction of a current chip packaging technology. Higher integration of the 3D IC indicates higher requirements on a bandwidth for interconnection and interworking between dies (dies) and a data amount. Therefore, it is urgent to use an interconnect interface with low power consumption and a small area between dies.

In a conventional 3D package on package, most dies are interconnected in a GPIO (general purpose input/output, general purpose input/output) manner. The GPIO may be applied to many application scenarios as an interconnection manner, but the GPIO has a relatively complex internal structure, occupies a relatively large area, and has relatively high power consumption (1 to 3 mW/Gbit). In addition, dies may be interconnected in a SERDES (Serializer/Deserializer, serializer/deserializer) manner. This interconnection manner requires PHY (physical layer, port physical layer) simulation, and has disadvantages such as need of customization, a complex structure, high power consumption (1 mW/Gbit), a relatively large occupied area, and many physical constraints. In addition, in a related technology, dies may be interconnected in a customized small I/O (small input/output) manner. This manner also has disadvantages such as need of PHY simulation and need of customization. Moreover, an occupied area and energy consumption do not meet expected requirements.

SOOMRO IFTIKHAR A ET AL: "Test Time Reduction of 3-D Stacked ICs Using Ternary Coded Simultaneous Bidirectional Signaling in Parallel Test Ports", IEEE TRANSACTIONS ON COMPUTER-AIDED DESIGN OF INTEGRATED CIRCUITS AND SYSTEMS, IEEE, USA, vol. 39, no. 12, 3 March 2020, discloses a test accessibility architecture based on ternary encoded simultaneous bidirectional signaling (SBS), intended for use in parallel test access mechanism (TAM) in system on chip (SoC)-based designs.

US 2019/050519 A1 discloses a circuit design verification method suitable for use with a 2.5D transceiver device potentially having hundreds of dice mounted on an interposer.

### SUMMARY

The invention is defined in the claims. In the following, parts of the description and drawings referring to embodiments which are not covered by the claims are not presented as embodiments of the invention, but as examples useful for understanding the invention.

Embodiments of this application provide a chip according to claim 1, a chip according to claim 6 and a chip package, to reduce power consumption and an area of a chip interconnect interface. The chip in the embodiments of this application may be a die (die) or a wafer (wafer). It should be understood that, in the chip interconnect interface of this application, the buffer that is a standard cell may include a buffer constructed by using a universal standard cell such as an inverter (that is, a NOT gate), an AND gate, an OR gate, a triple gate, a NAND gate, or a NOR gate, or may use a buffer in a standard cell library (std cell lib) provided by a chip manufacturer (for example but not limited to foundry).

The chip interconnect interface provided in this embodiment of this application uses the buffer that is a standard cell (std cell). On one hand, for the buffer in the chip interconnect interface, a standard cell (std cell) with a proper specification and a proper driving force may be directly selected based on an actual application scenario of the chip. That is, the buffer can be flexibly selected without customization. On the other hand, the standard cell (std cell) occupies a small area and has relatively low energy consumption. Therefore, requirements on an area and energy consumption between chip interconnect interfaces can be met. In other words, compared with use of complex interconnect interfaces (such as GPIO and SERDES) in a conventional technology, in this application, for interconnection between two chips with a relatively small gap (gap), a proper standard cell buffer with a relatively low driving force may be selected as an interconnect interface based on an actual chip requirement, thereby effectively reducing power consumption and an area of the chip interconnect interface.

In some possible implementations, the buffer may include one or more of a NOT gate, an AND gate, an OR gate, a triple gate, a NAND gate, or a NOR gate.

In some possible implementations, the buffer may use a buffer in a standard cell library (std cell lib) provided by a chip manufacturer (for example but not limited to foundry).

The chip interconnect interface is used as an input/output bidirectional interface. Both the receive buffer and the transmit buffer are disposed, and switching control is performed on the receive buffer and the transmit buffer by using the input control end and the output control end, to implement input or output of a data signal, so that an application scenario with dynamic switching between input and output or a scenario with an internal loopback requirement can be performed.

In some possible implementations, the transmit buffer includes a tristate buffer.

In some possible implementations, the chip interconnect interface further includes a level shift circuit, and the level shift circuit is disposed on a connection path between the buffer and the internal digital circuit. Level shift is performed by using the level shift circuit, to match a working voltage domain of the chip in which the interconnect interface is located.

In some possible implementations, the chip interconnect interface further includes an electrostatic discharge circuit, and the electrostatic discharge circuit is disposed on a connection path between the buffer and the connecting part of the active surface of the chip, to resolve an electrostatic problem introduced in a packaging process of a chip package. In the chip according to claim 1, the chip includes a plurality of signal channels, and the plurality of signal channels include a backup channel and a plurality of data channels. The chip further includes a test signal generation circuit, an n:1 multiplexer, and a D flip-flop, a 2:1 multiplexer, and a chip interconnect interface that are located in each signal channel, and the chip interconnect interface includes a transmit buffer. In the data channel, an input end of the D flipflop is connected to an output end of the 2:1 multiplexer, an output end of the D flip-flop is connected to an input end of the transmit buffer, a first input end of the 2:1 multiplexer is connected to the internal digital circuit in the chip, and a second input end of the 2:1 multiplexer is connected to the test signal generation circuit. In the backup channel, an input end of the D flip-flop is connected to an output end of the 2:1 multiplexer, an output end of the D flip-flop is connected to an input end of the transmit buffer, a first input end of the 2:1 multiplexer is connected to an output end of the n:1 multiplexer, and a second input end of the 2:1 multiplexer is connected to the test signal generation circuit. A plurality of input ends of the n:1 multiplexer are respectively connected to first input ends of 2:1 multiplexers located in the data channels.

In chip according to claim 6, the chip includes a plurality of signal channels, and the plurality of signal channels include a backup channel and a plurality of data channels. The chip further includes a chip interconnect interface, a D flip-flop, and a channel detection circuit that are located in each signal channel, and a 2:1 multiplexer located in each data channel, and the chip interconnect interface includes a receive buffer. In the data channel, an input end of the D flip-flop is connected to an output end of the receive buffer, an output end of the D flip-flop is connected to a first input end of the 2:1 multiplexer and the channel detection circuit, a second input end of the 2:1 multiplexer is connected to an output end of the D flip-flop in the backup channel, and an output end of the 2:1 multiplexer is connected to the internal digital circuit in the chip. In the backup channel, an input end of the D flip-flop is connected to an output end of the receive buffer, and an output end of the D flip-flop is connected to the channel detection circuit. A backup channel is disposed in the chip, and channel identification is performed in combination with test logic in each phase, so that when a yield problem occurs in a data channel, the data channel is switched to the backup channel for normal data transmission, to improve an overall yield and reliability of the chip.

An embodiment of this application further provides a chip package according to claim 10.

An embodiment not covered by the claims further provides a method for selecting a buffer in the chip interconnect interface according to any one of the foregoing possible implementations, including: simulating, by a standard cell, a first buffer, an auxiliary circuit, and a drive path model by using an SI simulation environment, and obtaining a simulation result. A type and a driving capability of the first buffer are determined based on an application scenario and a path parameter of the chip interconnect interface. The simulation result is used to determine, with reference to power consumption and an area of the first buffer, whether the first buffer is used as a buffer in the chip interconnect interface.

Compared with a related technology in which a complex interface circuit needs to be customized for a chip interconnect interface, resulting in disadvantages such as a large area and high power consumption of the interconnect interface, the selection method in this application can be compatible with an EDA development environment, and a buffer actually required in the chip interconnect interface is selected from std cells, so that an area and power consumption of the chip interconnect interface can be reduced.

### BRIEF DESCRIPTION OF DRAWINGS

FIG. 1 is a schematic diagram of some stacked interconnected chips in a chip package according to an embodiment of this application;
FIG. 2 shows a chip interconnect interface according to an embodiment of this application;
FIG. 3 shows a chip interconnect interface according to an embodiment of this application;
FIG. 4 shows a chip interconnect interface according to an embodiment of this application;
FIG. 5 shows a chip interconnect interface according to an embodiment of this application;
FIG. 6 is a schematic diagram of connection between interconnect interfaces of two chips according to an embodiment of this application;
FIG. 7 is a schematic diagram of connection between interconnect interfaces of two chips according to an embodiment of this application;
FIG. 8 is a schematic diagram of a local connection circuit of two chips according to an embodiment of this application; and
FIG. 9 is a schematic flowchart of a method for selecting a buffer in a chip interconnect interface according to an embodiment of this application.

### DESCRIPTION OF EMBODIMENTS

To make the objectives, technical solutions, and advantages of this application clearer, the following clearly and completely describes the technical solutions of this application with reference to the accompanying drawings of this application. It is clear that the described embodiments are merely a part rather than all of embodiments of this application. All other embodiments obtained by a person of ordinary skill in the art based on embodiments of this application without creative efforts shall fall within the protection scope of this application.

The terms "first", "second" and the like in the embodiments of the specification, claims, and accompanying drawings of this application are only used for a purpose of distinguishing description, but cannot be understood as indicating or implying relative importance, or indicating or implying a sequence. Moreover, the terms "including", "comprising" and any other variants mean to cover the non-exclusive inclusion, for example, a method, system, product, or device that includes a list of steps or units is not necessarily limited to those steps or units, but may include other steps or units not expressly listed or inherent to such a process, method, product, or device.

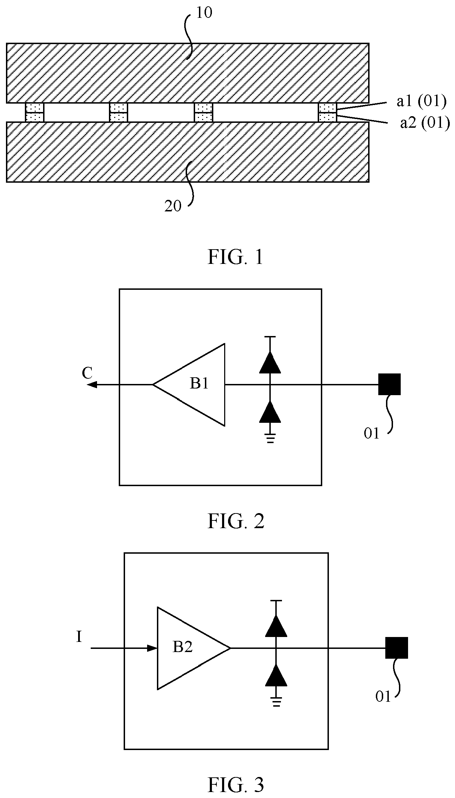

An embodiment of this application provides a chip package. As shown in FIG. 1, the chip package includes a plurality of stacked chips, for example, a first chip 10 and a second chip 20. In other words, the chip package is a 3D package on package. The chip in this embodiment of this application may be a die (die) or a wafer (wafer).

An application scenario of each chip in the 3D package on package is not limited in this application. For example, the first chip 10 and the second chip 20 may be a logic chip (that is, a logic chip), a pixel chip (that is, an image chip), a storage chip, or an interface chip.

It may be understood that, for a chip, referring to FIG. 1, a convex structure for electrically connecting to an external chip is disposed on an active surface of the chip, and the convex structure is used as a connecting part 01 on the active surface of the chip, to implement signal transmission between the chip and the external chip.

A manner of disposing the connecting part 01 is not limited in this application. For example, a micro bump (µ bump), an embedded micro bump (embedded µ bump), a gold bump (gold bump), or a copper bump (Cu bump) may be used. In addition, in practice, a connection manner of connecting parts of the two chips may be selected based on a specific form of disposing the connecting part 01. For example, hybrid bonding (hybrid bonding, HB) or fusion bonding (fusion bonding) may be used.

In addition, an internal digital circuit is disposed in the chip, and the internal digital circuit is specifically disposed based on different actual application scenarios of the chip. In addition, an interconnect interface (that is, a chip interconnect interface, which may also be referred to as a chip interconnect interface circuit) for connecting the connecting part located on the active surface to the internal digital circuit is further disposed in the chip. A data signal of the internal digital circuit of the chip needs to be input or output through the interconnect interface, to ensure normal interconnection and communication between chips.

For example, referring to FIG. 1, for the first chip 10 and the second chip 20 that perform interconnection and communication in the chip package, a first interconnect interface connected between an internal digital circuit and a first connecting part (such as a µ bump) a1 on an active surface is disposed in the first chip 10, and a second interconnect interface connected between an internal digital circuit and a second connecting part (such as a µ bump) a2 of an active surface is disposed in the second chip 20. The interconnect interfaces in the first chip 10 and the second chip 20 are connected by using the connecting parts (a1 and a2) located on the active surfaces, to implement interconnection and communication between the internal digital circuits. Certainly, a connection manner of the first connecting part and the second connecting part is not limited in this application.

In addition, it may be understood that a data signal between the first chip 10 and the second chip 20 is transmitted through the first interconnect interface and the second interconnect interface. In a signal transmission process, one of the first interconnect interface and the second interconnect interface is used as an output interface (output), and the other is used as an input interface (input). For example, the second interconnect interface in the second chip 20 receives a data signal that is output from the first chip 10 through the first interconnect interface, that is, the second interconnect interface is used as an input interface, and the first interconnect interface is used as an output interface.

In this application, a type (for example, unidirectional data transmission or bidirectional data transmission) of the interconnect interface located in the chip may be set as required. For example, unidirectional data transmission may be performed between the first interconnect interface and the second interconnect interface. In this case, one of the first interconnect interface and the second interconnect interface is used as an output interface, and the other is used as an input interface. For another example, bidirectional data transmission needs to be performed between the first interconnect interface and the second interconnect interface. In this case, the first interconnect interface and the second interconnect interface have both input and output functions, and switching control may be performed to ensure that one is used as an output interface and the other is used as an input interface.

Compared with a chip in a related technology that uses an interconnect interface such as GPIO (general purpose input/output, general purpose input/output), serdes (Serializer/Deserializer, serializer/deserializer), or small I/O (customized small input/output), and has disadvantages such as high power consumption, a large area, many physical constraints, and requiring customization, the chip interconnect interface provided in this embodiment of this application has advantages such as low power consumption, a small area, and requiring no customization.

The chip interconnect interface (which may also be referred to as an interconnect interface for short below) provided in this embodiment of this application is further described below.

An embodiment of this application provides a chip interconnect interface. The chip interconnect interface includes a buffer (buffer), the buffer uses a standard cell (standard cell, std cell for short), and one of an output end and an input end of the buffer is connected to a connecting part (for example, a µ bump) located on an active surface of a chip, and the other is connected to an internal digital circuit in the chip, to transmit a data signal between the connecting part and the internal digital circuit by using the buffer. Certainly, the internal digital circuit in the chip and the chip interconnect interface may be directly connected, or may be indirectly connected by using another circuit. This is not specifically limited in this application, and may be specifically set based on an application scenario of the chip.

It should be understood that, in the chip interconnect interface of this application, the buffer that is a standard cell may include a buffer constructed by using a universal standard cell such as an inverter (that is, a NOT gate), an AND gate, an OR gate, a triple gate, a NAND gate, or a NOR gate, or may use a buffer in a standard cell library (std cell lib) provided by a chip manufacturer (for example but not limited to foundry).

In conclusion, the buffer in the chip interconnect interface provided in this embodiment of this application uses a standard cell (std cell). In this case, on one hand, the buffer in the chip interconnect interface may directly select an std cell with a proper specification and a proper driving force based on an actual application scenario of the chip. That is, the buffer can be flexibly selected without customization. On the other hand, the standard cell (std cell) occupies a small area and has relatively low energy consumption. Therefore, requirements on an area and energy consumption between interconnect interfaces can be met. In other words, compared with use of complex interconnect interfaces (such as GPIO and SERDES) in a conventional technology, in this application, for interconnection between two chips with a relatively small gap (gap), a proper standard cell buffer with a relatively low driving force may be selected as an interconnect interface based on an actual chip requirement, thereby effectively reducing power consumption and an area of the chip interconnect interface.

In addition, based on different application scenarios of the chip interconnect interface in this application, different types of chip interconnect interfaces may be used, that is, types of buffers in the chip interconnect interfaces are different. For example, when the interconnect interface is used as an output interface, a transmit buffer (Tx buffer) is used, when the interconnect interface is used as an input interface, a receive buffer (Rx buffer) is used, and when the interconnect interface needs to implement input and output by switching, both a Tx buffer and an Rx buffer may be disposed in the interconnect interface, to implement bidirectional transmission of data signals. With reference to types of the chip interconnect interface, the following further describes specific disposition of a buffer disposed inside the chip interconnect interface.

For example, in some possible implementations, the chip interconnect interface is used as an input interface (input), and is applied only to a unidirectional scenario of signal input. In this case, as shown in FIG. 2, the buffer in the chip interconnect interface may be disposed as a receive buffer (Rx buffer) B1, an input end of the receive buffer B1 is connected to a connecting part (for example, a µ bump) 01 located on an active surface of a chip, an output end of the receive buffer B1 is connected to an internal digital circuit (not shown in FIG. 2) in the chip, and a data signal C received by the connecting part 01 of the active surface of the chip is transmitted to the internal digital circuit in the chip by using the receive buffer.

For another example, in some possible implementations, the chip interconnect interface is used as an output interface (output), and is applied only to a unidirectional scenario of signal output. In this case, as shown in FIG. 3, the buffer in the chip interconnect interface may be disposed as a transmit buffer (Tx buffer) B2, an input of the transmit buffer B2 is connected to an internal digital circuit (not shown in FIG. 3) in a chip, an output end of the transmit buffer B2 is connected to a connecting part (for example, a µ bump) 01 located on an active surface of the chip, and a data signal I output by the internal digital circuit in the chip is output to the connecting part 01 of the active surface of the chip by using the transmit buffer B2.

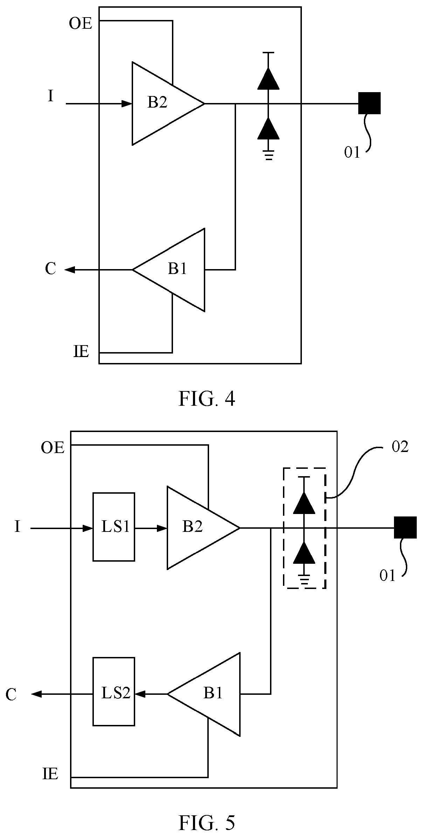

For still another example, in some possible implementations, the chip interconnect interface is used as an input/output bidirectional interface, so that an application scenario with dynamic switching between input (input) and output (output) or a scenario with an internal loopback requirement can be performed. In this case, as shown in FIG. 4, two buffers may be disposed in the chip interconnect interface, one is a receive buffer (Rx buffer) B1, and the other is a transmit buffer (Tx buffer) B2. An input end of the receive buffer B1 is connected to a connecting part 01 located on an active surface of a chip, an output end of the receive buffer B1 is connected to a first internal digital circuit in the chip, and the receive buffer B1 further includes an input control end IE. An input end of the transmit buffer B2 is connected to a second internal digital circuit in the chip. an output end of the transmit buffer B2 is connected to the connecting part 01 located on the active surface of the chip, and the transmit buffer B2 further includes an output control end OE. Switching control is performed on the receive buffer B1 and the transmit buffer B2 by using the input control end IE and the output control end OE, to input or output a data signal. For example, the input control end IE controls the receive buffer B1 to be enabled to input a data signal, and the output control end OE controls the transmit buffer B2 to be enabled to output a data signal.

It should be noted that, for the interconnect interface shown in FIG. 4 in which the data signals are bidirectionally transmitted by using the receive buffer B1 and the transmit buffer B2, the first internal digital circuit connected to the receive buffer B1 and the second internal digital circuit connected to the transmit buffer B2 may be a same internal digital circuit, or may be different internal digital circuits. This is not specifically limited in this application, and may be specifically set based on an application scenario of the chip.

Specific types of the receive buffer B1 and the transmit buffer B2 are not limited in this application. In practice, proper std cells may be selected as required.

For example, in some possible implementations, the transmit buffer B2 may use a triple gate circuit (which may also be referred to as a tristate buffer).

For example, in some possible implementations, the receive buffer B1 may use an AND gate circuit, a triple gate circuit, a NOT gate circuit, or the like.

In addition, to match a working voltage domain of the chip in which the interconnect interface is located, in some possible implementations, a level shift circuit (level shift) may be disposed on a connection path between the buffer and the internal digital circuit, to shift a voltage of a transmitted signal to the working voltage domain by using the level shift circuit. A specific structure of the level shift circuit is not limited in this application. In practice, a proper level shift circuit may be selected as required.

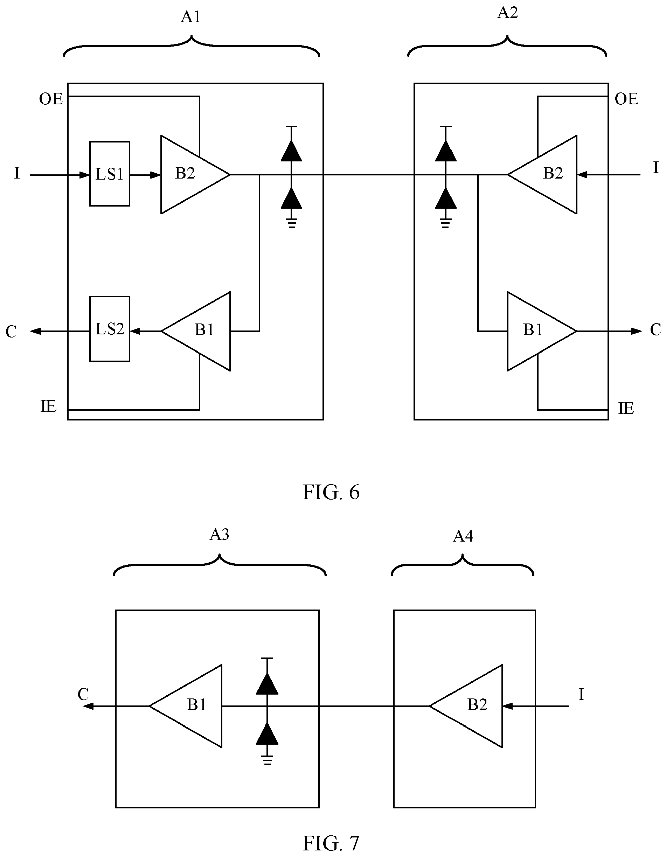

For example, as shown in FIG. 5, a level shift circuit LS1 may be disposed on a connection path between the input end of the transmit buffer B2 and the internal digital circuit, and a level shift circuit LS2 may be disposed on a connection path between the output end of the receive buffer B1 and the internal digital circuit. Certainly, for two chips that perform interconnection and communication, in practice, level shift circuits in interconnect interfaces of the two chips may be specifically disposed based on a specific application scenario. For example, in some possible implementations, as shown in FIG. 6, in two interconnect interfaces (A1 and A2) connected in two chips, only level shift circuits (LS1 and LS2) may be disposed in the interconnect interface A1, no level shift circuits are disposed in the interconnect interface A2, and level shift is performed by using the level shift circuits (LS1 and LS2) disposed in the interconnect interface A1, to meet level requirements of the two chips in a data signal transmission process. For another example, in some possible implementations, one level shift circuit may be disposed in each of the two interconnect interfaces (A1 and A2), to meet requirements of the two chips on working voltage domains. This is not limited in this application.

In addition, to resolve an electrostatic problem introduced in a packaging process of a chip package, in some possible implementations, referring to FIG. 2, FIG. 3, FIG. 4, FIG. 5, and FIG. 6, an electrostatic discharge (electrostatic discharge, ESD) circuit 02 may be disposed on a connection path between the buffer (for example, B1 or B2) in the interconnect interface and the connecting part 01 for electrostatic discharge, to achieve an objective of ESD prevention. A specific structure of the ESD prevention circuit 02 is not limited in this application, and may be selected as required in practice. For example, a minimum cell (cell) of an ESD circuit of a proper CDM (charged device model, charged device model) specification may be selected based on a chip area, a packaging process control capability, or the like. Certainly, for CDM specifications of different voltages and current levels, the ESD may be a plurality of cells connected in parallel.

In addition, it should be noted that the ESD prevention circuit 02 in the chip interconnect interface in this application may be flexibly disposed as required. For example, as shown in FIG. 7, in two connected interconnect interfaces, one interconnect interface is an input interface A3, and the other interconnect interface is an output interface A4, the ESD prevention circuit 02 may be disposed only in the input interface A3, and the ESD prevention circuit 02 is not disposed in the output interface A4. ESD prevention of the two interconnect interfaces can be achieved only by using the ESD prevention circuit 02 in the input interface A3.

Based on this, considering a yield problem in a packaging process, such as inter-chip packaging and through silicon via (through silicon via, TSV) fabrication, of a 3D package on package structure, in some possible implementations, a backup channel may be disposed in the chip, and channel identification is performed in combination with each phase, such as a CP (chip probing) test phase and an FT (final test) test phase, so that when a yield problem occurs in a data channel, the data channel is switched to the backup channel for normal data transmission, to improve an overall yield and reliability of the chip.

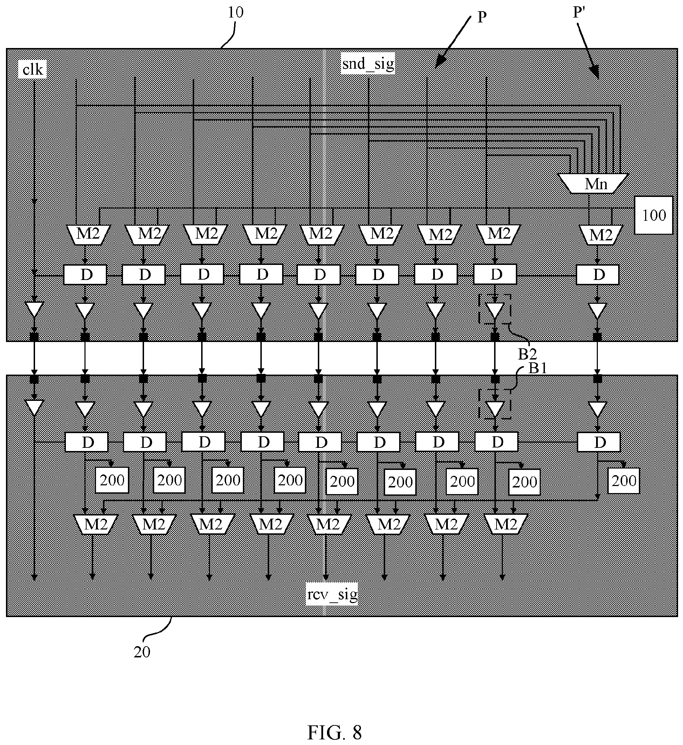

It may be understood that a data channel formed between two chips is based on connection between interconnect interfaces of the two chips. Referring to FIG. 8, the following uses an example in which unidirectional data transmission is performed between two chips (10 and 20). An interconnect interface in the first chip 10 is an output interface (that is, a Tx buffer B2 is used), and an interconnect interface in the second chip 20 is an input interface (that is, an Rx buffer B1 is used). Eight (this application is not limited thereto) data channels P and a backup channel P' are disposed in the first chip 10 and the second chip 20, and the channels in the first chip 10 and the channels in the second chip 20 are respectively connected in a one-to-one correspondence manner by using connecting parts located on active surfaces. The following describes circuit settings related to channel identification and switching to the backup channel. Referring to FIG. 8, in the first chip 10, each signal channel (including P and P') includes a D flip-flop and a 2:1 multiplexer M2. In addition, the first chip 10 further includes a test signal generation circuit 100 and an n:1 multiplexer Mn. For example, the test signal generation circuit 100 may use but is not limited to a PRBS generator (random pseudo binary sequence generator, pseudo random binary sequence generator).

In the data channel P of the first chip 10, an input end of the D flip-flop is connected to an output end of the 2:1 multiplexer M2, and an output end of the D flip-flop is connected to an input end of the Tx buffer B2. A first input end of the 2:1 multiplexer M2 is connected to an internal digital circuit in the first chip 10 (to receive a signal snd_sig sent from the internal digital circuit). A second input end of the 2:1 multiplexer M2 is connected to the test signal generation circuit 100.

In the backup channel P' of the first chip 10, an input end of the D flip-flop is connected to an output end of the 2:1 multiplexer M2, and an output end of the D flip-flop is connected to an input end of the Tx buffer B2. A first input end of the 2:1 multiplexer M2 is connected to an output end of the n:1 multiplexer Mn. A second input end of the 2:1 multiplexer M2 is connected to the test signal generation circuit 100.

Eight input ends of the n:1 multiplexer Mn are respectively connected to first input ends of 2:1 multiplexers M2 in the eight data channels P in a one-to-one correspondence manner. An output end of the Tx buffer B2 located in each channel (including P and P') is connected to the connecting part located on the active surface of the first chip 10.

Referring to FIG. 8, in the second chip 20, each data channel P includes a D flip-flop, a channel detection circuit 200, and a 2:1 multiplexer M2. The backup channel P' includes a D flip-flop and a channel detection circuit 200. For example, the channel detection circuit 200 may use but is not limited to a PRBS checker (random pseudo binary sequence check, pseudo random binary sequence checker).

In the data channel P, an input end of the D flip-flop is connected to an output end of the Rx buffer B1, and an output end of the D flip-flop is connected to a first input end of the 2:1 multiplexer M2 and the channel detection circuit 200. A second input end of the 2:1 multiplexer M2 is connected to an output end of the D flip-flop in the backup channel P', an output end of the 2:1 multiplexer M2 is connected to an internal digital circuit in the second chip 20, and the internal digital circuit receives a signal (rcv_sig) sent by using the output end of the 2:1 multiplexer M2.

In the backup channel P', an input end of the D flip-flop is connected to an output end of the Rx buffer B1, and an output end of the D flip-flop is connected to the channel detection circuit 200.

An input end of the Rx buffer B1 located in each channel (including P and P') is connected to the connecting part located on the active surface of the second chip 20.

Certainly, it may be understood that, for the D flip-flop in each signal channel (P and P'), related control needs to be performed by using a clock signal at a clock signal end, and a signal channel (that is, a clk channel) may be separately disposed in the first chip 10 and the second chip 20 for the clock signal, to transmit the clock signal, and control the D flip-flop.

In a process in which the first chip 10 and the second chip 20 perform interconnection and communication, each data channel P may be detected by a combination of the test signal generation circuit 100 (for example, the PRBS generate) and the channel detection circuit 200 (for example, the PRBS check).

Specifically, each signal channel is switched to a test phase by using the 2:1 multiplexers M2 in the first chip 10 and the second chip 20. A test signal generated by the test signal generation circuit 100 is transmitted to the second chip 20 through the D flip-flop in each signal channel and the interconnect interface (B2) of the first chip 10, and then received and detected by the channel detection circuit 200 after passing through the interconnect interface (B1) and the D flip-flop of the second chip 20. In this case, if the channel detection circuit 200 of each signal channel in the second chip 20 receives a normal test signal generated by the test signal generation circuit 100, it indicates that the signal channel in which the test signal is located is normal. If a channel detection circuit 200 in a data channel P fails to receive a normal test signal, it indicates that the data channel P in which the test signal is located is in an abnormal state. In this case, a data signal in the data channel P is switched to the backup channel P' by using the n:1 multiplexer Mn located in the first chip 10 for data transmission. Certainly, in a phase in which data transmission needs to be performed, the 2:1 multiplexers M2 in the first chip 10 and the second chip 20 need to be switched to a data transmission phase for data transmission.

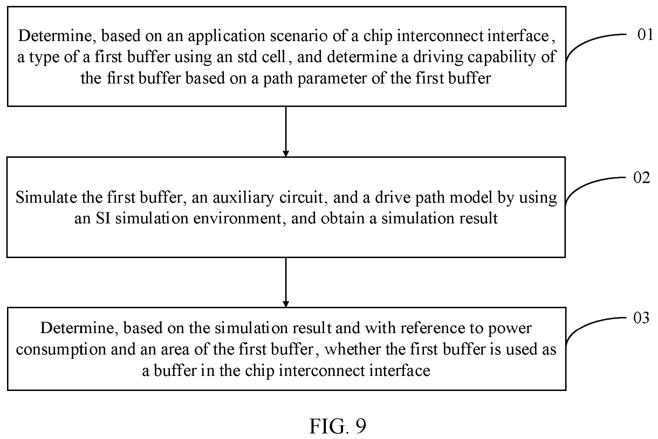

In addition, as described above, it can be learned that the buffer in the chip interconnect interface in this application uses a standard cell (std cell). In this case, factors such as an area and energy consumption of the chip interconnect interface are directly related to selection of the buffer. Based on this, an embodiment of this application provides a method for selecting a buffer in a chip interconnect interface. A buffer applicable to a chip interconnect interface can be selected by using the selection method. As shown in FIG. 9, the selection method includes the following steps.

Step 01: Determine, based on an application scenario of a chip interconnect interface, a type of a first buffer using an std cell, and determine a driving capability of the first buffer based on a path parameter of the first buffer.

For example, if the chip interconnect interface is used as an output interface, a type of Tx buffers may be selected from std cells, and in the Tx buffers of the determined type, a Tx buffer having an appropriate driving capability is selected based on a path parameter of a buffer in the chip interconnect interface.

It should be noted herein that the path parameter of the first buffer is a comprehensive information parameter of factors such as a path length and crosstalk of the first buffer in all phases between two chip interconnect interfaces. For example, the first buffer is a Tx buffer, and the path parameter is a comprehensive path parameter of all phases between the Tx buffer and an Rx buffer that is in another chip and that is interconnected to the Tx buffer.

Step 02: Simulate the first buffer, an auxiliary circuit, and a drive path model by using an SI simulation environment, and obtain a simulation result.

For example, the SI simulation environment is first established, and then the Tx buffer determined in step 01, the auxiliary circuit, and the drive path model are simulated, and a simulation result is obtained.

Certainly, it may be understood that, the simulation result can clearly indicate, in the chip interconnect interfaces for signal transmission, related parameters (such as a duty ratio and a peak value) of a signal output by the Tx buffer and a signal received by the Rx buffer.

Step 03: Determine, based on the simulation result and with reference to power consumption and an area of the first buffer, whether the first buffer is used as a buffer in the chip interconnect interface.

For example, the Tx buffer is evaluated based on the parameters, in the simulation result obtained in step 02, of the signals transmitted between the two chip interconnect interfaces and with reference to the power consumption and the area of the Tx buffer. If the power consumption and the area of the Tx buffer reach an actual expected target, the Tx buffer may be selected as a buffer in the chip interconnect interface. If the power consumption and the area of the Tx buffer do not reach the actual expected target, the processes of step 01 and step 02 may be repeated, until power consumption and an area of a Tx buffer reach the actual expected target, and the first buffer is determined as a buffer in the chip interconnect interface.

It should be noted that, the foregoing selection method is merely described by using a Tx buffer selection process as an example. Certainly, in practice, both a Tx buffer and an Rx buffer may be selected by using the selection method. After the buffer to be used in the chip interconnect interface is determined by using the selection method, customization is not required, and a standard digital code development mode and process can be used for implementation.

Compared with a related technology in which a complex interface circuit needs to be customized for a chip interconnect interface, resulting in disadvantages such as a large area and high power consumption of the interconnect interface, in the selection method in this application, a buffer actually required in the chip interconnect interface can be selected from std cells. In addition, the method can be compatible with a current EDA (electronic design automation, electronic design automation) development environment, thereby meeting requirements of the chip interconnect interface on an area and power consumption.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip, comprising an internal digital circuit and
a plurality of signal channels (P, P'), and the plurality of signal channels comprises a backup channel (P') and a plurality of data channels (P);
the chip further comprises a test signal generation circuit (100), an n:1 multiplexer (Mn), and a D flip-flop, a 2:1 multiplexer (M2), and a chip interconnect interface that are located in each signal channel (P, P'), and the chip interconnect interface comprises a transmit buffer (B2);
in each of the plurality of data channels (P), an input end of the D flip-flop is connected to an output end of the 2:1 multiplexer (M2), an output end of the D flip-flop is connected to an input end of the transmit buffer (B2), a first input end of the 2:1 multiplexer (M2) is connected to the internal digital circuit in the chip, and a second input end of the 2:1 multiplexer (M2) is connected to the test signal generation circuit (100);
in the backup channel (P'), an input end of the D flip-flop is connected to an output end of the 2:1 multiplexer (M2), an output end of the D flip-flop is connected to an input end of the transmit buffer (B2), a first input end of the 2:1 multiplexer (M2) is connected to an output end of the n:1 multiplexer (Mn), and a second input end of the 2:1 multiplexer (M2) is connected to the test signal generation circuit (100); and
a plurality of input ends of the n:1 multiplexer (Mn) are respectively connected to first input ends of 2:1 multiplexers (M2) located in the data channels (P),
wherein the transmit buffer (B2) is a standard cell;
the transmit buffer (B2) comprises the input end and an output end; and
the output end of the transmit buffer (B2) is connected to a connecting part (01) of an active surface of the chip, and the input end is connected to the internal digital circuit via the D flip-flop and the 2:1 multiplexer (M2);
and the connecting part (01) is connected to an external chip.

2. The chip according to claim 1, wherein the transmit buffer (B2) comprises one or more of a NOT gate, an AND gate, an OR gate, a tristate gate, a NAND gate, or a NOR gate.

3. The chip according to claim 1 or 2, wherein the transmit buffer (B2) comprises a tristate buffer.

4. The chip according to any one of claims 1 to 3, wherein the chip interconnect interface further comprises a level shift circuit (LS1, LS2), and the level shift circuit (LS1, LS2) is disposed on a connection path between the transmit buffer (B2) and the internal digital circuit.

5. The chip according to any one of claims 1 to 4, wherein the chip interconnect interface further comprises an electrostatic discharge circuit (02), and the electrostatic discharge circuit (02) is disposed on a connection path between the transmit buffer (B2) and the connecting part (01) of the active surface of the chip.

6. A chip comprising an internal digital circuit and
a plurality of signal channels (P, P'), and the plurality of signal channels comprise a backup channel (P') and a plurality of data channels (P);
the chip further comprises a chip interconnect interface, a D flip-flop, and a channel detection circuit (200) that are located in each signal channel (P, P'), and a 2:1 multiplexer (M2) located in each data channel (P, P'), and the chip interconnect interface comprises a receive buffer (B1);
in each of the plurality of data channels (P), an input end of the D flip-flop is connected to an output end of the receive buffer (B1), an output end of the D flip-flop is connected to a first input end of the 2:1 multiplexer (M2) and the channel detection circuit (200), a second input end of the 2:1 multiplexer (M2) is connected to an output end of the D flip-flop in the backup channel (P'), and an output end of the 2:1 multiplexer (M2) is connected to the internal digital circuit in the chip; and
in the backup channel (P'), an input end of the D flip-flop is connected to an output end of the receive buffer (B1), and an output end of the D flip-flop is connected to the channel detection circuit (200),
wherein the receive buffer (B1) is a standard cell;
the receive buffer (B1) comprises an input end and the output end; and
the input end of the receive buffer (B1) is connected to a connecting part (01) of an active surface of the chip, and the output end is connected to the internal digital circuit via the D flip-flop and the 2:1 multiplexer (M2);
and the connecting part (01) is connected to an external chip.

7. The chip according to claim 6, wherein the receive buffer (B1) comprises one or more of a NOT gate, an AND gate, an OR gate, a tristate gate, a NAND gate, or a NOR gate.

8. The chip according to any one of claims 6 to 7, wherein the chip interconnect interface further comprises a level shift circuit (LS1, LS2), and the level shift circuit (LS1, LS2) is disposed on a connection path between the receive buffer (B1) and the internal digital circuit.

9. The chip according to any one of claims 6 to 8, wherein the chip interconnect interface further comprises an electrostatic discharge circuit (02), and the electrostatic discharge circuit (02) is disposed on a connection path between the receive buffer (B1) and the connecting part (01) of the active surface of the chip.

10. A chip package, comprising a first chip (10) and a second chip (20) that are stacked, wherein the first chip (10) is the chip according to any one of claims 1 to 5, and the second chip (20) is the chip according to any of claims 6 to 9, and a connecting part (a1) located on an active surface of the first chip (10) is connected to a connecting part (a2) located on an active surface of the second chip (20).

## Patentansprüche

1. Chip, umfassend eine interne digitale Schaltung und
eine Vielzahl von Signalkanälen (P, P') und wobei die Vielzahl von Signalkanälen einen Sicherungskanal (P') und eine Vielzahl von Datenkanälen (P) umfasst;
der Chip ferner eine Testsignalerzeugungsschaltung (100), einen n:1-Multiplexer (Mn) und ein D-Flipflop, einen 2:1-Multiplexer (M2) und eine Chip-Verbindungsschnittstelle, die sich in jedem Signalkanal (P, P') befinden, umfasst, und wobei die Chip-Verbindungsschnittstelle einen Sendepuffer (B2) umfasst;
in jedem der Vielzahl von Datenkanälen (P) ein Eingangsende des D-Flipflops mit einem Ausgangsende des 2:1-Multiplexers (M2) verbunden ist, ein Ausgangsende des D-Flipflops mit einem Eingangsende des Sendepuffers (B2) verbunden ist, ein erstes Eingangsende des 2:1-Multiplexers (M2) mit der internen digitalen Schaltung in dem Chip verbunden ist und ein zweites Eingangsende des 2:1-Multiplexers (M2) mit der Testsignalerzeugungsschaltung (100) verbunden ist;
in dem Sicherungskanal (P') ein Eingangsende des D-Flipflops mit einem Ausgangsende des 2:1-Multiplexers (M2) verbunden ist, ein Ausgangsende des D-Flipflops mit einem Eingangsende des Sendepuffers (B2) verbunden ist, ein erstes Eingangsende des 2:1-Multiplexers (M2) mit einem Ausgangsende des n:1-Multiplexers (Mn) verbunden ist und ein zweites Eingangsende des 2:1-Multiplexers (M2) mit der Testsignalerzeugungsschaltung (100) verbunden ist; und
eine Vielzahl von Eingangsenden des n:1-Multiplexers (Mn) jeweils mit ersten Eingangsenden von 2:1-Multiplexern (M2), die sich in den Datenkanälen (P) befinden, verbunden ist,
wobei der Sendepuffer (B2) eine Standardzelle ist;
der Sendepuffer (B2) das Eingangsende und ein Ausgangsende umfasst; und
das Ausgangsende des Sendepuffers (B2) mit einem Verbindungsteil (01) einer aktiven Oberfläche des Chips verbunden ist und das Eingangsende über das D-Flipflop und den 2:1-Multiplexer (M2) mit der internen digitalen Schaltung verbunden ist;
und der Verbindungsteil (01) mit einem externen Chip verbunden ist.

2. Chip nach Anspruch 1, wobei der Sendepuffer (B2) eines oder mehrere eines NICHT-Gatters, eines UND-Gatters, eines ODER-Gatters, eines Dreizustandsgatters, eines NICHT-UND-Gatters oder eines NICHT-ODER-Gatters umfasst.

3. Chip nach Anspruch 1 oder 2, wobei der Sendepuffer (B2) einen Dreizustandspuffer umfasst.

4. Chip nach einem der Ansprüche 1 bis 3, wobei die Chip-Verbindungsschnittstelle ferner eine Pegelumsetzerschaltung (LS1, LS2) umfasst und die Pegelumsetzerschaltung (LS1, LS2) auf einem Verbindungspfad zwischen dem Sendepuffer (B2) und der internen digitalen Schaltung angeordnet ist.

5. Chip nach einem der Ansprüche 1 bis 4, wobei die Chip-Verbindungsschnittstelle ferner eine elektrostatische Entladungsschaltung (02) umfasst und die elektrostatische Entladungsschaltung (02) auf einem Verbindungspfad zwischen dem Sendepuffer (B2) und dem Verbindungsteil (01) der aktiven Oberfläche des Chips angeordnet ist.

6. Chip, umfassend eine interne digitale Schaltung und
eine Vielzahl von Signalkanälen (P, P') und wobei die Vielzahl von Signalkanälen einen Sicherungskanal (P') und eine Vielzahl von Datenkanälen (P) umfasst;
der Chip ferner eine Chip-Verbindungsschnittstelle, ein D-Flipflop und eine Kanalerkennungsschaltung (200), die sich in jedem Signalkanal (P, P') befinden, und einen 2:1-Multiplexer (M2), der sich in jedem Datenkanal (P, P') befindet, umfasst und die Chip-Verbindungsschnittstelle einen Empfangspuffer (B1) umfasst;
in jedem der Vielzahl von Datenkanälen (P) ein Eingangsende des D-Flipflops mit einem Ausgangsende des Empfangspuffers (B1) verbunden ist, ein Ausgangsende des D-Flipflops mit einem ersten Eingangsende des 2:1-Multiplexers (M2) und der Kanalerkennungsschaltung (200) verbunden ist, ein zweites Eingangsende des 2:1-Multiplexers (M2) mit einem Ausgangsende des D-Flipflops in dem Sicherungskanal (P') verbunden ist und ein Ausgangsende des 2:1-Multiplexers (M2) mit der internen digitalen Schaltung in dem Chip verbunden ist; und
in dem Sicherungskanal (P') ein Eingangsende des D-Flipflops mit einem Ausgangsende des Empfangspuffers (B1) verbunden ist und ein Ausgangsende des D-Flipflops mit der Kanalerkennungsschaltung (200) verbunden ist,
wobei der Empfangspuffer (B1) eine Standardzelle ist;
der Empfangspuffer (B1) ein Eingangsende und das Ausgangsende umfasst; und
das Eingangsende des Empfangspuffers (B1) mit einem Verbindungsteil (01) einer aktiven Oberfläche des Chips verbunden ist und das Ausgangsende über das D-Flipflop und den 2:1-Multiplexer (M2) mit der internen digitalen Schaltung verbunden ist;
und der Verbindungsteil (01) mit einem externen Chip verbunden ist.

7. Chip nach Anspruch 6, wobei der Empfangspuffer (B1) eines oder mehrere eines NICHT-Gatters, eines UND-Gatters, eines ODER-Gatters, eines Dreizustandsgatters, eines NICHT-UND-Gatters oder eines NICHT-ODER-Gatters umfasst.

8. Chip nach einem der Ansprüche 6 bis 7, wobei die Chip-Verbindungsschnittstelle ferner eine Pegelumsetzerschaltung (LS1, LS2) umfasst und die Pegelumsetzerschaltung (LS1, LS2) auf einem Verbindungspfad zwischen dem Empfangspuffer (B1) und der internen digitalen Schaltung angeordnet ist.

9. Chip nach einem der Ansprüche 6 bis 8, wobei die Chip-Verbindungsschnittstelle ferner eine elektrostatische Entladungsschaltung (02) umfasst und die elektrostatische Entladungsschaltung (02) auf einem Verbindungspfad zwischen dem Empfangspuffer (B1) und dem Verbindungsteil (01) der aktiven Oberfläche des Chips angeordnet ist.

10. Chipgehäuse, umfassend einen ersten Chip (10) und einen zweiten Chip (20), die übereinandergestapelt sind, wobei der erste Chip (10) der Chip nach einem der Ansprüche 1 bis 5 ist und der zweite Chip (20) der Chip nach einem der Ansprüche 6 bis 9 ist, und ein Verbindungsteil (a1) auf einer aktiven Oberfläche des ersten Chips (10) mit einem Verbindungsteil (a2) auf einer aktiven Oberfläche des zweiten Chips (20) verbunden ist.

## Revendications

1. Puce comprenant un circuit numérique interne et
une pluralité de canaux de signal (P, P'), et la pluralité de canaux de signal comprend un canal de secours (P') et une pluralité de canaux de données (P) ;
la puce comprend également un circuit de génération de signal de test (100), un multiplexeur n:1 (Mn), une bascule D, un multiplexeur 2:1 (M2) et une interface d'interconnexion de puce qui sont situés dans chaque canal de signal (P, P'), et l'interface d'interconnexion de puce comprend un tampon de transmission (B2) ; dans chacun de la pluralité de canaux de données (P), une extrémité d'entrée de la bascule D est connectée à une extrémité de sortie du multiplexeur 2:1 (M2), une extrémité de sortie de la bascule D est connectée à une extrémité d'entrée du tampon de transmission (B2), une première extrémité d'entrée du multiplexeur 2:1 (M2) est connectée au circuit numérique interne dans la puce, et une seconde extrémité d'entrée du multiplexeur 2:1 (M2) est connectée au circuit de génération de signal de test (100) ;
dans le canal de secours (P'), une extrémité d'entrée de la bascule D est connectée à une extrémité de sortie du multiplexeur 2:1 (M2), une extrémité de sortie de la bascule D est connectée à une extrémité d'entrée du tampon de transmission (B2), une première extrémité d'entrée du multiplexeur 2:1 (M2) est connectée à une extrémité de sortie du multiplexeur n:1 (Mn), et une seconde extrémité d'entrée du multiplexeur 2:1 (M2) est connectée au circuit de génération de signal de test (100) ; et une pluralité d'extrémités d'entrée du multiplexeur n:1 (Mn) sont respectivement connectées aux premières extrémités d'entrée de multiplexeurs 2:1 (M2) situés dans les canaux de données (P),
dans laquelle le tampon de transmission (B2) est une cellule standard ;
le tampon de transmission (B2) comprend l'extrémité d'entrée et une extrémité de sortie ; et
l'extrémité de sortie du tampon de transmission (B2) est connectée à une partie de connexion (01) d'une surface active de la puce, et l'extrémité d'entrée est connectée au circuit numérique interne via la bascule D et le multiplexeur 2:1 (M2) ;
et la partie de connexion (01) est connectée à une puce externe.

2. Puce selon la revendication 1, dans laquelle le tampon de transmission (B2) comprend une ou plusieurs d'une porte NON, d'une porte ET, d'une porte OU, d'une porte à trois états, d'une porte NON-ET ou d'une porte NON-OU.

3. Puce selon la revendication 1 ou 2, dans laquelle le tampon de transmission (B2) comprend un tampon à trois états.

4. Puce selon l'une quelconque des revendications 1 à 3, dans laquelle l'interface d'interconnexion de puce comprend également un circuit de décalage de niveau (LS1, LS2), et le circuit de décalage de niveau (LS1, LS2) est disposé sur un chemin de connexion entre le tampon de transmission (B2) et le circuit numérique interne.

5. Puce selon l'une quelconque des revendications 1 à 4, dans laquelle l'interface d'interconnexion de puce comprend également un circuit de décharge électrostatique (02), et le circuit de décharge électrostatique (02) est disposé sur un chemin de connexion entre le tampon de transmission (B2) et la partie de connexion (01) de la surface active de la puce.

6. Puce comprenant un circuit numérique interne et
une pluralité de canaux de signal (P, P'), et la pluralité de canaux de signal comprennent un canal de secours (P') et une pluralité de canaux de données (P) ;
la puce comprend également une interface d'interconnexion de puce, une bascule D et un circuit de détection de canal (200) qui sont situés dans chaque canal de signal (P, P'), et un multiplexeur 2:1 (M2) situé dans chaque canal de données (P, P'), et l'interface d'interconnexion de puce comprend un tampon de réception (B1) ;
dans chacun de la pluralité de canaux de données (P), une extrémité d'entrée de la bascule D est connectée à une extrémité de sortie du tampon de réception (B1), une extrémité de sortie de la bascule D est connectée à une première extrémité d'entrée du multiplexeur 2:1 (M2) et au circuit de détection de canal (200), une seconde extrémité d'entrée du multiplexeur 2:1 (M2) est connectée à une extrémité de sortie de la bascule D dans le canal de secours (P'), et une extrémité de sortie du multiplexeur 2:1 (M2) est connectée au circuit numérique interne dans la puce ; et dans le canal de secours (P'), une extrémité d'entrée de la bascule D est connectée à une extrémité de sortie du tampon de réception (B1), et une extrémité de sortie de la bascule D est connectée au circuit de détection de canal (200),
dans laquelle le tampon de réception (B1) est une cellule standard ;
le tampon de réception (B1) comprend une extrémité d'entrée et l'extrémité de sortie ; et
l'extrémité d'entrée du tampon de réception (B1) est connectée à une partie de connexion (01) d'une surface active de la puce, et l'extrémité de sortie est connectée au circuit numérique interne via la bascule D et le multiplexeur 2:1 (M2) ;
et la partie de connexion (01) est connectée à une puce externe.

7. Puce selon la revendication 6, dans laquelle le tampon de réception (B1) comprend une ou plusieurs d'une porte NON, d'une porte ET, d'une porte OU, d'une porte à trois états, d'une porte NON-ET ou d'une porte NON-OU.

8. Puce selon l'une quelconque des revendications 6 et 7, dans laquelle l'interface d'interconnexion de puce comprend également un circuit de décalage de niveau (LS1, LS2), et le circuit de décalage de niveau (LS1, LS2) est disposé sur un chemin de connexion entre le tampon de réception (B1) et le circuit numérique interne.

9. Puce selon l'une quelconque des revendications 6 à 8, dans laquelle l'interface d'interconnexion de puce comprend également un circuit de décharge électrostatique (02), et le circuit de décharge électrostatique (02) est disposé sur un chemin de connexion entre le tampon de réception (B1) et la partie de connexion (01) de la surface active de la puce.

10. Boîtier de puce, comprenant une première puce (10) et une seconde puce (20) qui sont empilées, dans lequel la première puce (10) est la puce selon l'une quelconque des revendications 1 à 5, et la seconde puce (20) est la puce selon l'une quelconque des revendications 6 à 9, et une partie de connexion (al) située sur une surface active de la première puce (10) est connectée à une partie de connexion (a2) située sur une surface active de la seconde puce (20).
